# EUROPEAN PATENT APPLICATION

(11) **EP 4 603 619 A1**
(43) Date of publication of application: **20.08.2025**
(21) Application number: 25158044.5
(22) Date of filing: 14.02.2025
(51) Int. Cl.: C23C 16/04, B29C 33/30, C04B 35/80, C04B 35/83, C04B 41/45, C23C 16/458, F01D 5/28

(54) **LOCAL PART MASKING FOR IMPROVED UNIFORMITY IN CERAMIC MATRIX COMPOSITES**

(30) Priority: 15.02.2024 US 202418442808
(71) Applicant: RTX Corporation, Farmington, CT 06032 (US)
(72) Inventor: LENZ, Brendan, Farmington, 06032 (US); SHE, Ying, Farmington, 06032 (US); KAVOSI, Jamshid, Farmington, 06032 (US); BAZSHUSHTARI, Afshin, Farmington, 06032 (US)
(74) Representative: Dehns

(57) **Abstract**

An arrangement of tooling assemblies (28) within a CVI reactor (10) having a plurality of levels (22) sequentially disposed between an inlet (16) and an outlet (18) of the reactor (10) includes a first plurality of tooling assemblies (28) disposed in a first level (22-1) of the reactor (10) closest to the inlet (16), each of the first plurality of tooling assemblies (28) including a plurality of porous walls (32) having a first porosity, and at least one connector (34) securing the plurality of porous walls (32) together. The arrangement further includes a second plurality of tooling assemblies (28) disposed in a second level (22-3) of the reactor (10) further from the inlet (16) than the first level (22-1), each of the second plurality of tooling assemblies (28) including a plurality of porous walls (32) having a second porosity, and at least one connector (34) securing the plurality of porous walls (32) together. The second porosity is greater than the first porosity.

## Description

### BACKGROUND

The present invention relates to chemical vapor infiltration (CVI), and more particularly to improved tooling for CVI.

CVI is a process that enables high-purity deposition of both interface coatings (IFCs) and matrix in ceramic matrix composite (CMC) systems. One drawback of the CVI process is that there are often deposition rate gradients that form along the span of the reactor, due to the depletion of reactant gas and formation of byproduct gas as reaction occurs. Deposition rate gradients can impact overall process yield, as parts often have property requirements that are linked to the IFC or matrix thicknesses within the CMC microstructure. As such, means for minimizing deposition rate gradients are desirable.

### SUMMARY

An arrangement of tooling assemblies within a CVI reactor having a plurality of levels sequentially disposed between an inlet and an outlet of the reactor includes a first plurality of tooling assemblies disposed in a first level of the reactor closest to the inlet, each of the first plurality of tooling assemblies including a plurality of porous walls having a first porosity, and at least one connector securing the plurality of porous walls together. The arrangement further includes a second plurality of tooling assemblies disposed in a second level of the reactor further from the inlet than the first level, each of the second plurality of tooling assemblies including a plurality of porous walls having a second porosity, and at least one connector securing the plurality of porous walls together. The second porosity is greater than the first porosity.

A method of performing CVI on a plurality of preforms includes placing a first of the plurality of preforms in a first tooling assembly including a plurality of porous walls having a first porosity, and at least one connector securing the plurality of porous walls together, placing a second of the plurality of preforms in a second tooling assembly including a plurality of porous walls having a second porosity, and at least one connector securing the plurality of porous walls together. The second porosity is greater than the first porosity. The method further includes placing the first tooling assembly in a first level of a reactor closest to an inlet of the reactor, placing the second tooling assembly in a second level of the reactor further from the inlet than the first level, and flowing a reactive gas through the inlet.

### BRIEF DESCRIPTION OF THE DRAWINGS

FIG. 1 is a schematic illustration of a CVI reactor containing preform tooling assemblies.
FIG. 2 is a schematic, cross-sectional view of a tooling assembly for use in the CVI reactor of FIG. 1.
FIG. 3 is a schematic, cross-sectional view of walls from three different tooling assemblies.

While the above-identified figures set forth one or more embodiments of the present disclosure, other embodiments are also contemplated, as noted in the discussion. In all cases, this disclosure presents the invention by way of representation and not limitation. It should be understood that numerous other modifications and embodiments can be devised by those skilled in the art, which fall within the scope and spirit of the principles of the invention. The figures may not be drawn to scale, and applications and embodiments of the present invention may include features and components not specifically shown in the drawings.

### DETAILED DESCRIPTION

This disclosure presents modifiable tooling assemblies for use in countering the natural gradients in deposition observed within a CVI reactor. More specifically, individual tooling assembly porosities can be varied across a group of tooling assemblies placed in a reactor based on proximity to the inlet or outlet of the reactor. The disclosed tooling assemblies allow for an increase in yield of batches of CMC components with more consistent microstructures without the need to redesign/reconfigure the reactor or significantly vary process parameters.

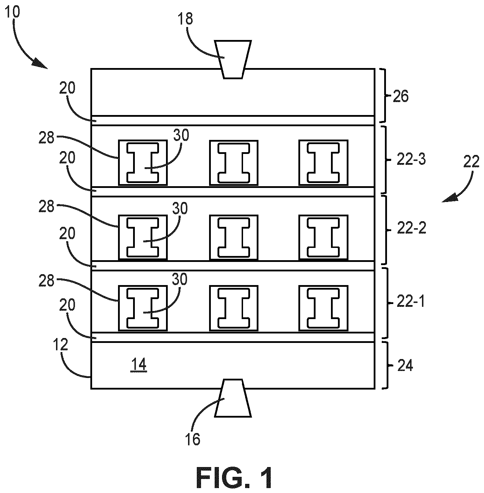

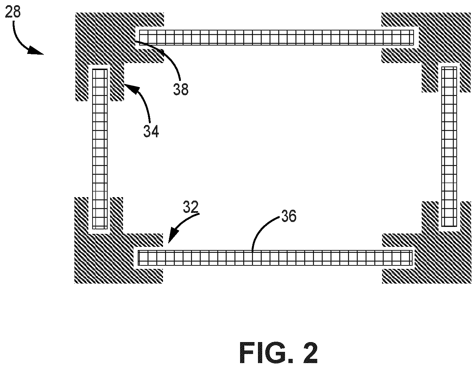

FIG. 1 is a schematic illustration of CVI reactor 10. Reactor 10 includes body 12 defining an inner volume 14. Reactor 10 further includes inlet 16 for receiving a flow of reactive gas, indicated by arrows, from one or more gas sources (not shown), and outlet 18 for exhausting the flow of gas from inner volume 14. A vacuum source can be in communication with outlet 18 for drawing the flow of reactive gas from inner volume 14. The flow of reactive gas can include a reactive precursor and a process/carrier gas which are combined to form the reactive gas. Multiple support plates 20 can partition inner volume 14 into multiple (e.g., two to ten) vertically stacked deposition/infiltration levels, or stages 22. Each plate 20 can include through-holes (not shown in FIG. 1) for allowing the flow of reactive gas to pass into each level 22. Preheating and/or premixing zone 24 can optionally be disposed between inlet 16 and a first plate 20 for heating the incoming flow of reactive gas to a desired temperature. Reaction completion zone 26 can be disposed between outlet 18 and a last plate 20. As shown in FIG. 1, reactor 10 includes three levels 22, labeled in the upstream to downstream direction (i.e., based on the flow of reactive gas) as 22-1, 22-2, and 22-3. Tooling assemblies 28 containing preforms 30 can be disposed within each level 22. Preforms 30 can be net or near net shape fibrous ceramic structures. Tooling assemblies 28 can be three-dimensional (e.g., polyhedral) assemblies with porous faces/walls as is described in greater detail below with respect to FIG. 2.

FIG. 2 is a schematic, cross-sectional view of one tooling assembly 28 shown for simplicity without an enclosed preform 30. Tooling assembly 28 can be formed by assembling multiple walls 32 together using connectors 34. Pores 36 are formed in each wall 32 and allow reactive gas to reach the enclosed preform. In an exemplary embodiment, walls 32 can be replaceable filters formed from reticular vitreous carbon (RVC). In such an example, pores 36 can be defined by a matrix of open cells and ligaments with an open porosity greater than 90%, and more specifically, around 97%. In an alternative embodiment, walls 32 can be plates of graphite with pores 36 being machined through-holes. Connectors 34 can be formed from graphite and can include slots 38 for receiving walls 32. Tooling assembly 28 can further include external graphite support rods (not depicted) for additional support of walls 32. Connectors 34 can have various geometries for forming tooling assemblies 28 having different polyhedral shapes, such as a square, rectangular, or triangular prism, or an octahedron, to name a few non-limiting examples. In an alternative embodiment, walls 32 can include curvature and be at least partially complementary to a shape of preform 30 (e.g., an airfoil and platform(s)) arranged, for example, as two halves. In such an embodiment, connectors 34 can be clips, bands, or other suitable connector for holding the halves together.

Because deposition rate gradients can form across reactor 10 during the CVI process, it can be generally beneficial to vary the porosity of walls 32 of tooling assemblies 28 in each level 22. RVC materials can be manufactured with different pore sizes, such as 5 to 100 pores-per-inch (PPI). Thus, for walls 32 formed from RVC, porosity can be a function of PPI and wall thickness. Walls 32 of tooling assemblies 28 in upstream-most level 22-1 of FIG. 1 can be less porous/have a lower porosity than walls 32 of tooling assemblies 28 in level 22-2, and walls 32 of tooling assemblies 28 in intermediate level 22-2 can be less porous than walls 32 of tooling assemblies 28 in downstream-most level 22-3. Stated another way, walls 32 of tooling assemblies 28 in upstream-most level 22-1 can be the least porous, and walls 32 of tooling assemblies 28 in downstream-most level 22-3 can be the most porous. This can be true for a reactor with any number n of levels 22, with wall 32 porosities in intermediate levels 22 falling between the upstream-most and downstream-most levels 22.

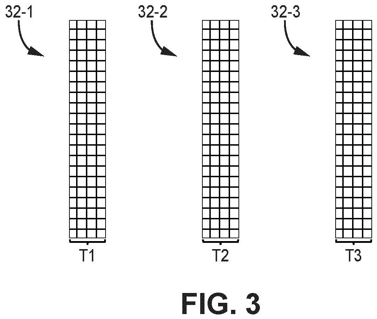

FIG. 3 is a schematic, cross-sectional view of portions of three individual walls 32 from three different tooling assemblies 28 intended for placement at different levels 22 within reactor 10. As such, walls 32 are labeled as 32-1, 32-2, and 32-3 as being used in tooling assemblies 28 from levels 22-1, 22-2, and 22-3, respectively. Each wall 32-1, 32-2, and 32-3 can be representative of the other walls 32 of a respective tooling assembly 28. Each wall 32-1, 32-2, and 32-3 has a respective thickness T1, T2, and T3, and a respective PPI-1, PPI-2, and PPI-3. Thickness can range from 0.0625 in (1.588 mm) to 0.25 in (6.35 mm), which can include an intermediate thickness of 0.125 in (3.175 mm). Further, as stated above, PPI values can range from 5 to 100 PPI, and can include intermediate values of 20 PPI and 45 PPI. Wall 32-1 can have a lower porosity than wall 32-2 which can have a lower porosity than wall 32-3. To achieve such result, in a first example, T1 can equal T2 which can equal T3, but PPI-1 (e.g., 5 PPI) can be less than PPI-2 (e.g., 20 PPI) which can be less than PPI-3 (e.g., 45 PPI). In a second example, PPI-1 can equal PPI-2 which can equal PPI-3, but T1 (e.g., 0.25 in) can be greater than T2 (e.g., 0.125) which can be greater than T3 (e.g., 0.0625 in). In a third example, T1, T2, and T3 can be varied as well as PPI-1, PPI-2, and PPI-3.

Configured in this way, tooling assemblies 28 act to meter the deposition rate of the reactant gas on preforms 30 within a given level 22 to create a more uniform deposition rate across reactor 10. Whereas the highest deposition rate would normally be observed in level 22-1, and the lowest deposition rate in level 32-3, the porosity of tooling assemblies 28 in each level 22 can be varied such that reactants deposit on preforms 30 within each level at a similar rate.

To infiltrate and/or densify a batch of preforms 30 using tooling assemblies 28, tooling assemblies 28 can be assembled with walls 32 having the requisite porosities based on the intended level 22 for each tooling assembly 28. Such determination can be made using software modeling considering factors such as number of levels 22 and preforms 30, as well as process parameters (e.g., time, temperature, pressure, reactive gas constituents). Tooling assemblies 28 can then be placed into reactor 10 and exposed to the flow of reactive gases. Tooling assemblies 28 can be used when infiltrating preforms 30 via CVI, to deposit interface coatings (e.g., layers of BN, SiC, Si-doped BN, etc.) and/or to form a matrix (e.g., SiC) to create a CMC component. Such CMC components can be incorporated into aerospace, maritime, or industrial equipment, to name a few, non-limiting examples.

### Discussion of Possible Embodiments

The following are non-exclusive descriptions of possible embodiments of the present invention.

An arrangement of tooling assemblies within a CVI reactor having a plurality of levels sequentially disposed between an inlet and an outlet of the reactor includes a first plurality of tooling assemblies disposed in a first level of the reactor closest to the inlet, each of the first plurality of tooling assemblies including a plurality of porous walls having a first porosity, and at least one connector securing the plurality of porous walls together. The arrangement further includes a second plurality of tooling assemblies disposed in a second level of the reactor further from the inlet than the first level, each of the second plurality of tooling assemblies including a plurality of porous walls having a second porosity, and at least one connector securing the plurality of porous walls together. The second porosity is greater than the first porosity.

The arrangement of the preceding paragraph can optionally include any one or more of the following features, configurations and/or additional components:
The above arrangement can further include a third plurality of tooling assemblies disposed in a third level between the first level and the second level, each of the third plurality of tooling assemblies including a plurality of porous walls having a third porosity, and at least one connector securing the plurality of porous walls together.

In any of the above arrangements, the third porosity can be greater than the first porosity and less than the second porosity.

In any of the above arrangements, the plurality of porous walls of each of the first, second, and third plurality of tooling assemblies can be formed from reticulated vitreous carbon.

In any of the above arrangements, the plurality of porous walls of the first tooling assembly can have a first pores-per-inch value, the plurality of porous walls of the second tooling assembly can have a second pores-per-inch value, and the plurality of porous walls of the third tooling assembly can have a third pores-per-inch value.

In any of the above arrangements, the first pores-per-inch value can be different from the second pores-per-inch value, and the second pores-per-inch value can be different from the third pores-per-inch value.

In any of the above arrangements, each of the first, second, and third pores-per-inch values can range from 5 to 100.

In any of the above arrangements, each of the plurality of porous walls of the first tooling assembly can have a first thickness, each of the plurality of porous walls of the second tooling assembly can have a second thickness, and each of the plurality of porous walls of the third tooling assembly can have a third thickness.

In any of the above arrangements, the first thickness can be different from the second thickness, and the second thickness can be different from the third thickness.

In any of the above arrangements, each of the first, second, and third thicknesses can range from 0.0625 in to 0.25 in.

In any of the above arrangements, the plurality of porous walls of each of the first, second, and third plurality of tooling assemblies can be formed from graphite.

In any of the above arrangements, the at least one connector of at least one of the first, second, and third plurality of tooling assemblies can be formed from graphite.

In any of the above arrangements, each of the first, second, and third plurality of tooling assemblies can have a polyhedral geometry.

A method of performing CVI on a plurality of preforms includes placing a first of the plurality of preforms in a first tooling assembly including a plurality of porous walls having a first porosity, and at least one connector securing the plurality of porous walls together, placing a second of the plurality of preforms in a second tooling assembly including a plurality of porous walls having a second porosity, and at least one connector securing the plurality of porous walls together. The second porosity is greater than the first porosity. The method further includes placing the first tooling assembly in a first level of a reactor closest to an inlet of the reactor, placing the second tooling assembly in a second level of the reactor further from the inlet than the first level, and flowing a reactive gas through the inlet.

The method of the preceding paragraph can optionally include any one or more of the following features, configurations and/or additional steps:
The above method can further include placing a third of the plurality of preforms in a third tooling assembly including a plurality of porous walls having a third porosity, and at least one connector securing the plurality of porous walls together, and placing the third tooling assembly in a third level of the reactor between the first level and the second level.

In any of the above methods, the third porosity can be greater than the first porosity and less than the second porosity.

In any of the above methods, the plurality of porous walls of the first, second, and third tooling assemblies can be formed from reticulated vitreous carbon.

In any of the above methods, the plurality of porous walls of the first tooling assembly can have a first pores-per-inch value, the plurality of porous walls of the second tooling assembly can have a second pores-per-inch value, and the plurality of porous walls of the third tooling assembly can have a third pores-per-inch value.

In any of the above methods, each of the plurality of porous walls of the first tooling assembly can have a first thickness, each of the plurality of porous walls of the second tooling assembly can have a second thickness, and each of the plurality of porous walls of the third tooling assembly can have a third thickness.

Any of the above methods can further include varying at least one of the first, second, and third pores-per-inch values and the first, second, and third thicknesses.

While the invention has been described with reference to an exemplary embodiment(s), it will be understood by those skilled in the art that various changes may be made and equivalents may be substituted for elements thereof without departing from the scope of the invention. **In** addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. An arrangement of tooling assemblies (28) within a CVI reactor (10) having a plurality of levels (22) sequentially disposed between an inlet (16) and an outlet (18) of the reactor (10), the arrangement comprising:
a first plurality of tooling assemblies (28) disposed in a first level (22-1) of the reactor (10) closest to the inlet (16), each of the first plurality of tooling assemblies (28) comprising:
a plurality of porous walls (32) having a first porosity; and
at least one connector (34) securing the plurality of porous walls (32) together; and
a second plurality of tooling assemblies (28) disposed in a second level (22-3) of the reactor (10) further from the inlet (16) than the first level (22-1), each of the second plurality of tooling assemblies (28) comprising:
a plurality of porous walls (32) having a second porosity; and
at least one connector (34) securing the plurality of porous walls (32) together,
wherein the second porosity is greater than the first porosity.

2. The arrangement of claim 1 and further comprising:
a third plurality of tooling assemblies (28) disposed in a third level (22-2) between the first level (22-1) and the second level (22-3), each of the third plurality of tooling assemblies (28) comprising:
a plurality of porous walls (32) having a third porosity; and
at least one connector (34) securing the plurality of porous walls (32) together.

3. The arrangement of claim 2, wherein the third porosity is greater than the first porosity and less than the second porosity.

4. The arrangement of claim 2 or 3, wherein the plurality of porous walls (32) of each of the first, second, and third plurality of tooling assemblies (28) are formed from reticulated vitreous carbon.

5. The arrangement of claim 2, 3 or 4, wherein:
the plurality of porous walls (32) of the first tooling assembly (28) has a first pores-per-inch value;
the plurality of porous walls (32) of the second tooling assembly (28) has a second pores-per-inch value; and
the plurality of porous walls (32) of the third tooling assembly (28) has a second pores-per-inch value.

6. The arrangement of claim 5, wherein:
the first pores-per-inch value is different from the second pores-per-inch value, and the second pores-per-inch value is different from the third pores-per-inch value; and/or
each of the first, second, and third pores-per-inch values ranges from 5 to 100.

7. The arrangement of any of claims 2 to 6, wherein:
each of the plurality of porous walls (32) of the first tooling assembly (28) has a first thickness;
each of the plurality of porous walls (32) of the second tooling assembly (28) has a second thickness; and
each of the plurality of porous walls (32) of the third tooling assembly (28) has a third thickness.

8. The arrangement of claim 7, wherein the first thickness is different from the second thickness, and wherein the second thickness is different from the third thickness,
wherein, optionally, each of the first, second, and third thicknesses range from 0.0625 in to 0.25 in (1.588 mm to 6.35 mm).

9. The arrangement of any of claims 2 to 8, wherein the plurality of porous walls (32) of each of the first, second, and third plurality of tooling assemblies (28) are formed from graphite.

10. The arrangement of any of claims 2 to 9, wherein the at least one connector (34) of at least one of the first, second, and third plurality of tooling assemblies (28) is formed from graphite.

11. The arrangement of any of claims 2 to 10, wherein each of the first, second, and third plurality of tooling assemblies (28) have a polyhedral geometry.

12. A method of performing CVI on a plurality of preforms (30), the method comprising:
placing a first of the plurality of preforms (30) in a first tooling assembly (28) comprising:
a plurality of porous walls (32) having a first porosity; and
at least one connector (34) securing the plurality of porous walls (32) together;
placing a second of the plurality of preforms (30) in a second tooling assembly (28) comprising:
a plurality of porous walls (32) having a second porosity; and
at least one connector (34) securing the plurality of porous walls (32) together,
wherein the second porosity is greater than the first porosity;
placing the first tooling assembly (28) in a first level (22-1) of a reactor (10) closest to an inlet (16) of the reactor (10);
placing the second tooling assembly (28) in a second level (22-3) of the reactor (10) further from the inlet (16) than the first level (22-1); and
flowing a reactive gas through the inlet (16),
wherein, optionally, the plurality of porous walls (32) of the first, second, and third tooling assemblies (28) are formed from reticulated vitreous carbon.

13. The method of claim 12 and further comprising:
placing a third of the plurality of preforms (30) in a third tooling assembly (28) comprising:
a plurality of porous walls (32) having a third porosity; and
at least one connector (34) securing the plurality of porous walls (32) together; and
placing the third tooling assembly (28) in a third level (22-2) of the reactor (10) between the first level (22-1) and the second level (22-3),
wherein, optionally, the third porosity is greater than the first porosity and less than the second porosity.

14. The method of claim 13, wherein:
the plurality of porous walls (32) of the first tooling assembly (28) has a first pores-per-inch value;
the plurality of porous walls (32) of the second tooling assembly (28) has a second pores-per-inch value; and
the plurality of porous walls (32) of the third tooling assembly (28) has a second pores-per-inch value.

15. The method of claim 14, wherein:
each of the plurality of porous walls (32) of the first tooling assembly (28) has a first thickness;
each of the plurality of porous walls (32) of the second tooling assembly (28) has a second thickness; and
each of the plurality of porous walls (32) of the third tooling assembly (28) has a third thickness,
wherein, optionally, the method further comprises varying at least one of the first, second, and third pores-per-inch values and the first, second, and third thicknesses.
